# EUROPEAN PATENT SPECIFICATION

(11) **EP 4 652 600 B1**
(45) Date of publication and mention of the grant of the patent: **28.10.2026**
(21) Application number: 24721486.9
(22) Date of filing: 11.03.2024
(51) Int. Cl.: G11C 16/04, G11C 16/10, G11C 16/34

(54) **METHODS AND APPARATUSES FOR OPERATING A MEMORY DEVICE**
VERFAHREN UND VORRICHTUNGEN ZUM BETRIEB EINER SPEICHERVORRICHTUNG
PROCÉDÉS ET APPAREILS DE FONCTIONNEMENT DE DISPOSITIF DE MÉMOIRE

(43) Date of publication of application: 26.11.2025
(73) Proprietor: Yangtze Memory Technologies Co., Ltd., Wuhan, Hubei 430000 (CN)
(72) Inventor: TIAN, Yaoyao, Wuhan, Hubei 430000 (CN); LI, Da, Wuhan, Hubei 430000 (CN); XU, Feng, Wuhan, Hubei 430000 (CN); LI, Xinran, Wuhan, Hubei 430000 (CN); QI, Wei, Wuhan, Hubei 430000 (CN)
(74) Representative: Lippert Stachow Patentanwälte Rechtsanwälte
(86) International application number: PCT/CN2024/080907
(87) International publication number: WO 2025/189309

(56) References cited:
- US-A1- 2020 098 439
- US-A1- 2022 165 341
- US-B1- 11 004 525

## Description

### TECHNICAL FIELD

This present disclosure generally relates to the field of semiconductor technology, and more particularly, to systems and methods for managing over-programming in memory devices.

### BACKGROUND

Flash memory is a low-cost, high-density, nonvolatile solid-state storage medium that can be electrically erased and reprogrammed. Flash memory includes NOR flash memory and NAND flash memory. Various operations can be performed by flash memory, for example, program (write) and erase operations, to change the threshold voltage of each memory cell to a respective level. For NAND flash memory, an erase operation can be performed at the block level, a program operation can be performed at the page level, and a read operation can be performed at the page level.
US 2022/165341 A1 discloses a memory apparatus with a block of memory cells, wherein each of the memory cells is connected to one of a plurality of word lines and are also arranged in strings and configured to retain a threshold voltage within a common range of threshold voltages. A control circuit is configured to determine an erase upper tail voltage of a distribution of the threshold voltage of the memory cells following an erase operation, and also configured to calculate a program voltage to apply to each of selected ones of the plurality of word lines associated with the memory cells to program the memory cells during a program operation based on the erase upper tail voltage.
US 2020/098439 A1 discloses a memory system with a plurality of memory blocks, a peripheral circuit configured to apply a check voltage for acquiring check data to a target memory block and apply program voltages to the target memory block in a pre-program operation for the target memory block, and a controller which is configured to control the peripheral circuit, determine status information on the target memory block based on the check data, and variably apply a program start voltage to the target memory block based on the status to information in the pre-program operation.

### SUMMARY

The present disclosure relates to memory devices, memory systems, and methods for managing over-programming of flash memory. The method of operating a memory device includes, before erasing data in a memory block of the memory device, programing memory cells in the memory block to a pre-programmed state, and identifying a threshold voltage of the memory cells in the pre-programmed state. The method further includes, after erasing the data in the memory block, programing memory cells in the memory block using at least one program pulse determined based on the threshold voltage. Identifying the threshold voltage of the memory cells comprises applying a set of read voltages to the memory cells, determining a set of fail bit counts, FBCs, of the memory cells corresponding to the set of the read voltages, and identifying the threshold voltage based on the set of FBCs.

While generally described as computer-implemented software embodied on tangible media that processes and transforms the respective data, some or all of the aspects may be computer-implemented methods or further included in respective systems or other devices for performing this described functionality. The details of these and other aspects and implementations of the present disclosure are set forth in the accompanying drawings and the description below. Other features, objects, and advantages of the disclosure will be apparent from the description and drawings, and from the claims.

### BRIEF DESCRIPTION OF DRAWINGS

FIG. 1 illustrates an example of a schematic diagram of a memory device including peripheral circuits, according to some aspects of the present disclosure.
FIG. 2 illustrates an example of a side view of cross-sections of a memory cell array including NAND memory strings, according to some aspects of the present disclosure.
FIG. 3 illustrates some example peripheral circuits, according to some aspects of the present disclosure.
FIG. 4A illustrates an example program pulse, according to some aspects of the present disclosure.
FIG. 4B illustrates an example incremental step pulse programming scheme, according to some aspects of the present disclosure.
FIG. 5A illustrates a schematic diagram of an example threshold voltage distribution of memory cells in a memory device, according to some aspects of the present disclosure.
FIG. 5B illustrates a schematic diagram of an example threshold voltage distribution of memory cells in a memory device after a pre-program operation, according to some aspects of the present disclosure.
FIG. 6 illustrates an example schematic diagram of a page buffer of a memory device, according to some aspects of the present disclosure.
FIGS. 7A-7D illustrate schematic diagrams of example threshold voltage distributions of memory cells in a memory device, according to some aspects of the present disclosure.
FIG. 8 illustrates an example flow chart of performing a program operation after an erase operation, according to some aspects of the present disclosure.
FIG. 9 illustrates a block diagram of an example system having a memory device, according to some aspects of the present disclosure.
FIG. 10A illustrates a diagram of a memory card having a memory device, according to some aspects of the present disclosure.
FIG. 10B illustrates a diagram of a solid-state drive (SSD) having a memory device, according to some aspects of the present disclosure.
Like reference numbers and designations in the various drawings indicate like elements.

### DETAILED DESCRIPTION

A memory device, such as a NAND memory device, can store data by changing the logic state of memory cells in the memory device. In a program operation, a memory cell changes from an erased state to a programmed state. Specifically, by applying a program voltage to a control gate of the memory cell, electron charges can tunnel through a dielectric layer and remain trapped in a storage layer of the memory device. The charges trapped in the storage layer can increase the threshold voltage of the memory cell. The increased threshold voltage can represent the programmed state of the memory cell.

In a NAND memory device, data that occupy the memory cells need to be erased before new data can be stored. That is, the memory device needs to perform an erase operation before performing a next program operation on the memory cells, which is generally referred to as a program-erase cycle (P/E cycle). In some cases, when a memory cell has undergone multiple P/E cycles, the memory cell can be programmed by the program voltage to a threshold voltage higher than the intended value (i.e., the threshold voltage of a fresh memory cell programmed using the same program voltage). In such cases, the memory cells can be "over-programmed" after undergoing multiple P/E cycles. The over-programming issue can occur due to several factors, such as excessive charges trapped in the storage layer, degradation of the insulating oxide layer, wear-and-tear of the memory cells. The over-programming issue can affect the reliability of the memory device, such as causing read failures and disturbing adjacent memory cells.

This present disclosure provides techniques to adjust the program voltage for memory cells that have undergone multiple P/E cycles. In some implementations, before erasing data in a memory block, the memory cells in the memory block are first programmed to a pre-programmed state. One or more verify operations can identify a threshold voltage that represents the pre-programmed state. Based on the identified threshold voltage representing the pre-programmed state, the memory device can adjust the program voltage for a next program operation on the memory block. For example, if the identified threshold voltage is higher than a pre-set voltage, it indicates that the memory cells in the memory block will likely be over-programmed if a pre-defined program voltage is applied in the next program operation. As such, the program voltage for the next program operation should be adjusted to be lower than the pre-defined program voltage to mitigate the over-programming issue.

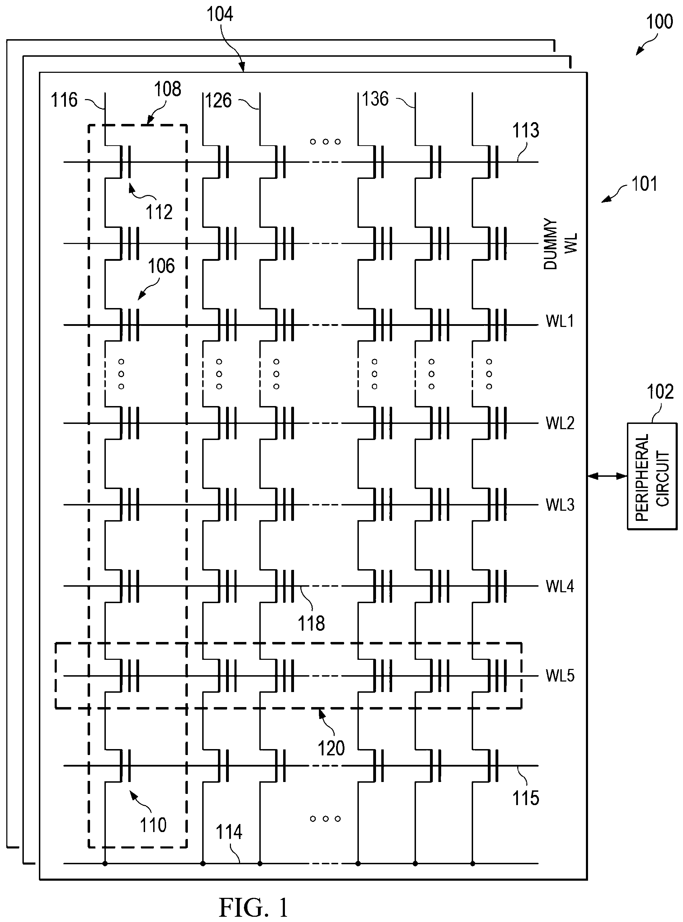

FIG. 1 illustrates an example of a schematic circuit diagram of a memory device 100 including peripheral circuits, according to some aspects of the present disclosure. The memory device 100 can include a memory cell array 101 and peripheral circuits 102 coupled to the memory cell array 101. The memory cell array 101 can be a NAND Flash memory cell array in which memory cells 106 are provided in the form of an array of NAND memory strings 108 each extending vertically above a substrate (not shown in FIG. 1). In some implementations, each NAND memory string 108 includes a plurality of memory cells 106 coupled in series and stacked vertically. Each memory cell 106 can hold a continuous, analog value, such as an electrical voltage or charge that depends on the number of electrons trapped within a storage layer of the memory cell 106. The logic state (i.e., data) of each memory cell 106 in the block 104 can be determined based on the threshold voltage Vₜₕ of the memory cell 106. Each memory cell 106 can be a floating gate type memory cell including a floating-gate transistor, or a charge trap type memory cell including a charge-trap transistor.

In some implementations, each memory cell 106 is a single-level cell (SLC) with two possible memory states that can store one bit of data. For example, the first memory state "0" can correspond to a first range of voltages, and the second memory state "1" can correspond to a second range of voltages. In some implementations, each memory cell 106 is a multi-level cell (MLC) that is capable of storing more than one bit of data in more than two memory states. For example, the MLC can store two bits per cell, three bits per cell (also known as triple-level cell (TLC)), or four bits per cell (also known as a quad-level cell (QLC)). Each MLC can be programmed to support a range of possible nominal storage values. In one example, if each MLC stores two bits of data, then the MLC can be programmed to one of three possible programming levels from an erased state by writing one of three possible nominal storage values to the cell. A fourth nominal storage value can be used for the erased state.

As shown in FIG. 1, each NAND memory string 108 can include a source select gate (SSG) 110 at its source end and a drain select gate (DSG) 112 at its drain end. The SSG 110 and the DSG 112 can be configured to activate selected NAND memory strings 108 (columns of the array) during read and program operations. In some implementations, the sources of NAND memory strings 108 in the same block 104 are coupled through a same source line (SL) 114, e.g., a common SL. In other words, NAND memory strings 108 in the same block 104 have an array common source (ACS), according to some implementations. The DSG 112 of each NAND memory string 108 is coupled to a respective bit line 116 from which data can be read or written via an output bus (not shown), according to some implementations. In some implementations, each NAND memory string 108 is configured to be selected or deselected by applying a select voltage (e.g., above the threshold voltage of the transistor having the DSG 112) or a deselect voltage (e.g., 0 V) to the respective DSG 112 through one or more DSG lines 113, and/or by applying a select voltage (e.g., above the threshold voltage of the transistor having the SSG 110) or a deselect voltage (e.g., 0 V) to the respective SSG 110 through one or more SSG lines 115.

As shown in FIG. 1, NAND memory strings 108 can be organized into multiple blocks 104, each of which can have a common source line 114 coupled to the ACS. In some implementations, each block 104 can serve as a basic data unit for erase operations, such that memory cells 106 on the same block 104 are erased at the same time. To erase memory cells 106 in a selected block 104, the source lines 114 coupled to the selected block 104 and unselected blocks in the same plane can be biased with an erase voltage (Vₑᵣₛ). For example, the erase voltage can be a high positive voltage (e.g., 20 V or more). In some implementations, an erase operation can be performed at a half-block level, a quarter-block level, or a level having any suitable number of blocks or fractions of a block.

The memory cells 106 of adjacent NAND memory strings 108 can be coupled through word lines 118. The word line 118 can select which row of memory cells 106 is affected by read and program operations. In some implementations, the memory cell 106 is a SLC, and each word line 118 is coupled to a page 120 of memory cells 106, which is the basic data unit for program operations. If the memory cell 106 is an MLC that stores two bits of data per cell, each word line 118 can correspond to two pages. If memory cell 106 is a TLC, each word line 118 can correspond to three pages. If memory cell 106 is a QLC, each word line 118 can correspond to four pages. The size of a page 120 in bits is associated with the number of NAND memory strings 108 coupled by word line 118 in a block 104. Each word line 118 can include a gate line coupled to a plurality of control gates (gate electrodes) of a plurality of memory cells 106 in the respective page 120. Example word lines shown in FIG. 1 include dummy WL, WL1, WL2, WL3, WL4, and WL5 that are between one or more DSG lines 113 and one or more SSG lines 115.

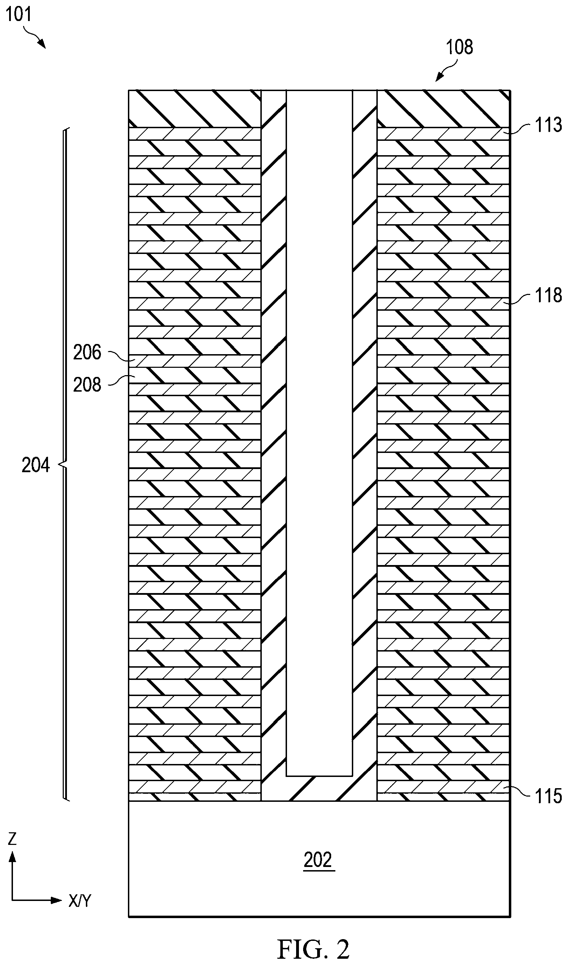

FIG. 2 illustrates an example of a side view of cross-sections of a memory cell array 101 including NAND memory strings 108, according to some aspects of the present disclosure. As shown in FIG. 2, the NAND memory string 108 can extend vertically through a memory stack 204 above a substrate 202. The substrate 202 can include silicon (e.g., single crystalline silicon), silicon germanium (SiGe), gallium arsenide (GaAs), germanium (Ge), silicon on insulator (SOI), germanium on insulator (GOI), or any other suitable materials.

The memory stack 204 can include pairs of interleaved gate conductive layers 206 and gate-to-gate dielectric layers 208. The quantity of the pairs of the interleaved gate conductive layers 206 and gate-to-gate dielectric layers 208 in a memory stack 204 can determine the quantity of memory cells 106 in memory cell array 101. The gate conductive layer 206 can include conductive materials including, but not limited to, one or more of tungsten (W), cobalt (Co), copper (Cu), aluminum (Al), polysilicon, doped silicon, or silicide. In some implementations, each gate conductive layer 206 includes a metal layer, such as a tungsten layer. In some implementations, each gate conductive layer 206 includes a doped polysilicon layer. Each gate conductive layer 206 can include control gates surrounding the memory cells 106, the DSG 112, or the SSG 110, and can extend laterally as the DSG line 113 at the top of memory stack 204, the SSG line 115 at the bottom of memory stack 204, or the word lines 118 between the DSG line 113 and the SSG line 115.

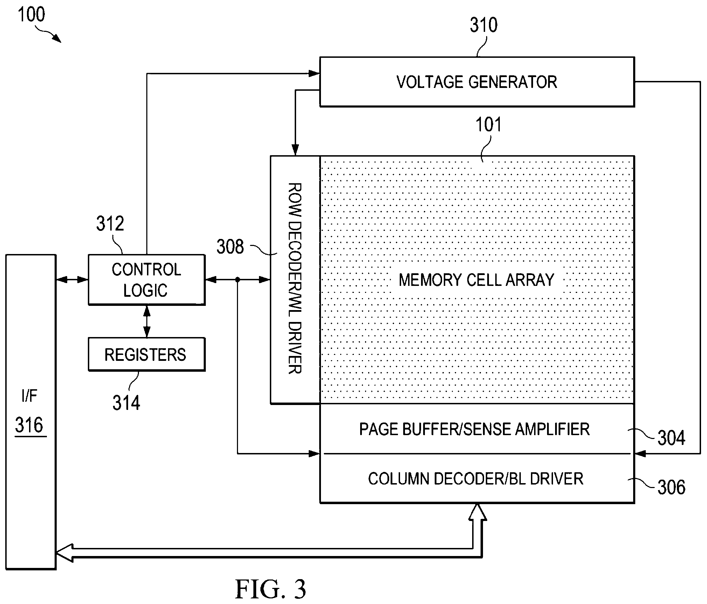

Peripheral circuits 102 can be coupled to the memory cell array 101 through bit lines 116,126,136, word lines 118, source lines 114, SSG lines 115, and DSG lines 113. The peripheral circuits 102 can include any suitable analog, digital, and mixed-signal circuits for facilitating the operations of the memory cell array 101 by applying and sensing voltage signals and/or current signals to and from each target memory cell 106 through bit lines 116, word lines 118, source lines 114, SSG lines 115, and DSG lines 113. The peripheral circuits 102 can include various types of peripheral circuits formed using metal-oxide-semiconductor (MOS) technologies. For example, FIG. 3 illustrates some example peripheral circuits, according to some aspects of the present disclosure. The example peripheral circuits include a page buffer/sense amplifier 304, a column decoder/bit line driver 306, a row decoder/word line driver 308, a voltage generator 310, control logic 312, registers 314, an interface 316, and a data bus. In some examples, additional peripheral circuits not shown in FIG. 3 may be included as well.

The page buffer/sense amplifier 304 can be configured to read and program (write) data from and to memory cell array 101 according to the control signals from control logic 312. In an example, the page buffer/sense amplifier 304 may store one page of program data (write data) to be programmed into one page 120 of the memory cell array 101. In another example, the page buffer/sense amplifier 304 may perform program verify operations to ensure that the data has been properly programmed into memory cells 106 coupled to selected word lines 118. In still another example, the page buffer/sense amplifier 304 may also sense the low power signals from the bit line 116 that represents a data bit stored in memory cell 106, and amplify the small voltage swing to recognizable logic levels in a read operation. The column decoder/bit line driver 306 can be configured to be controlled by the control logic 312 and select one or more NAND memory strings 108 by applying bit line voltages generated from the voltage generator 310.

The row decoder/word line driver 308 can be configured to be controlled by the control logic 312 and select/deselect blocks 104 of the memory cell array 101 and select/deselect word lines 118 of the block 104. The row decoder/word line driver 308 can be further configured to drive word lines 118 using word line voltages generated from the voltage generator 310. In some implementations, the row decoder/word line driver 308 can also select/deselect and drive SSG lines 115 and DSG lines 113. As described below in detail, the row decoder/word line driver 308 is configured to apply a program voltage to selected word line 118 in a program operation on memory cell 106 coupled to selected word line 118.

The voltage generator 310 can be configured to be controlled by the control logic 312 and generate the word line voltages (e.g., read voltage, program voltage, pass voltage, local voltage, verify voltage, etc.), bit line voltages, and source line voltages to be supplied to the memory cell array 101.

The control logic 312 can be coupled to each peripheral circuit described above and configured to control operations of each peripheral circuit. The registers 314 can be coupled to the control logic 312 and include status registers, command registers, and address registers for storing status information, command operation codes (OP codes), and command addresses for controlling the operations of each peripheral circuit.

The interface 316 can be coupled to the control logic 312 and act as a control buffer to buffer and relay control commands received from a host (not shown) to the control logic 312 and status information received from the control logic 312 to the host. The interface 316 can also be coupled to the column decoder/bit line driver 306 via a data bus, and act as a data input/output (I/O) interface and a data buffer to buffer and relay data to and from the memory cell array 101.

Referring back to FIG. 1, in some implementations, a NAND flash memory can be configured to operate in a single-level cell (SLC) mode. In some implementations, the memory cell 106 can be in an erased state ER or a programmed state P1. Initially, the memory cells 106 in the block 104 can be reset to the erased state ER, by removing the trapped electron charges in the storage layer of the memory cell 106. The trapped charge carriers can be removed by implementing a negative voltage difference between the control gate of the memory cell 106 and the channel of the memory cell. In some implementations, the negative voltage difference can be implemented by setting the control gate of memory cell 106 to the ground, and applying a high positive voltage (i.e., an erase voltage Vₑᵣₛ) to the ACS. At the erased state ER ("state ER" or logic "0"), the threshold voltage Vₜₕ of the memory cell 106 can be reset to the lowest value.

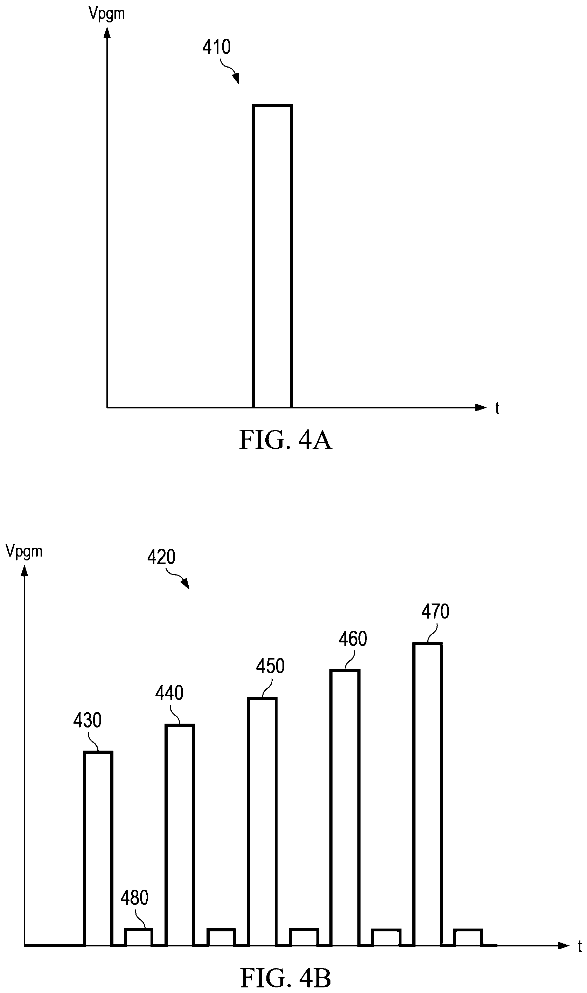

The memory cell 106 can be programmed from state ER to a programmed state P1 ("state P1" or logic "0"). In some implementations, during a program operation, a program pulse 410 as shown in FIG. 4A can be applied to the word line 118 coupled to the memory cell. The program pulse 410 can implement a positive voltage difference between the control gate and channel of the memory cell 106. For example, the program pulse 410 can have a program voltage V_{pgm} (e.g., a positive voltage between 10 V and 30 V), and can have a pulse length (e.g., a time duration between 1 µs to 30 µs) during which the program voltage is applied. During the program operation, the corresponding bit line 116 connecting to the memory cell 106 can be connected to the ground. As a result, electron charges can be injected into the storage layer of the memory cell 106, thereby increasing the threshold voltage Vₜₕ of the memory cell 106. Accordingly, the memory cell 106 is programmed to state P1.

In some implementations, to increase storage capacity, a NAND flash memory can also be configured to operate in a multi-level cell (MLC) mode, a triple-level cell (TLC) mode, a quad-level cell (QLC) mode, or a combination of any of these modes. In the SLC mode, as mentioned above, a memory cell stores 1 bit of data and has two logic states, logic {1 and 0}, i.e., states ER and P1. In the MLC mode, a memory cell stores 2 bits of data, and has four logic states, logic {11, 10, 01, and 00}, i.e., states ER, P1, P2, and P3. In the TLC mode, a memory cell stores 3 bits of data, and has eight logic states, logic {111, 110, 101, 100, 011, 010, 001, 000}, i.e., states ER, and states P1-P7. In the QLC mode, a memory cell stores 4 bits of data and has 16 logic states, logic {1111, 1110, 1101, 1100, 1011, 1010, 1001, 1000, 0111, 0110, 0101, 0100, 0011, 0010, 0001, 0000}, i.e., states ER, and states P1-P15.

In some implementations, memory cells of MLCs, TLCs and QLCs can be programmed to different programmed states using an incremental step pulse programming (ISPP) scheme 420, as shown in FIG. 4B. The ISPP scheme 420 can include a plurality of program pulses 430, 440, 450, 460, 470, and the memory device can apply several program pulses to program the memory cell 106 to a certain programmed state. Each program pulse can have a program voltage V_{pgm} (e.g., a positive voltage between 10 V and 30 V), and can have a pulse length (e.g., a time duration between 1 µs to 30 µs) during which the program voltage is applied. In some implementations, a starting program pulse 430 can have a program voltage V_{pgm_start}, and the program voltages of the following program pulses 440, 450, 460, 470 each increment by voltage ΔV_{pgm}. The pulse length of the program pulses 430, 440, 450, 460, 470 can be the same.

In some implementations, the ISPP scheme 420 further includes at least one verify voltage 480 after a program pulse (e.g., the program pulse 430). The memory device can perform a verify operation using the verify voltage 480 to determine whether the memory cell 106 has been properly programmed to a target programmed state. For example, the memory device can apply the verify voltage 480 to the word line of the selected memory cell, and a pass voltage Vₚₐₛₛ to word lines of unselected memory cells that are coupled to the same bit line as the selected memory cell. If the verify operation indicates that the memory cell 106 has not been properly programmed to the target programmed state, the memory device can apply another program pulse (e.g., the program pulse 440) to the memory cell 106. In some implementations, the ISPP scheme 420 can include a verify voltage following each program pulse 430, 440, 450, 460, 470.

For example, the TLC cells can be programmed using the ISPP scheme 420 from state ER with a lowest threshold voltage, to state P1 with a higher threshold voltage, or to state P7 with a highest threshold voltage. Each logic state of the memory cells can correspond to a specific range of threshold voltage Vₜₕ of the memory cells, where the threshold voltage Vₜₕ distribution of each state can be represented by a probability density.

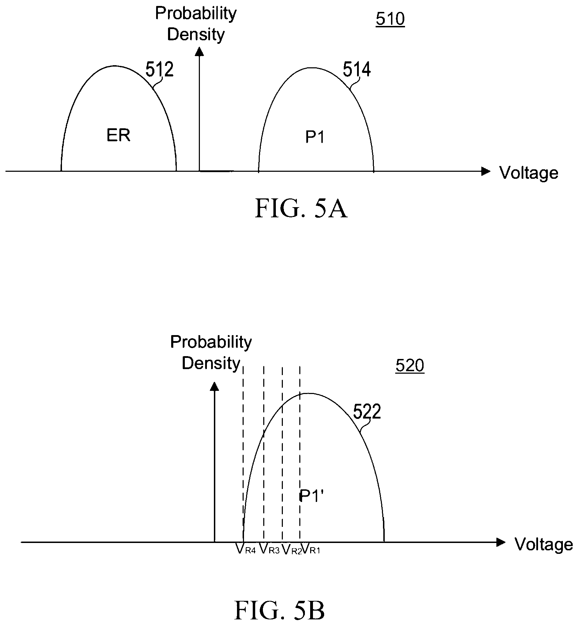

FIG. 5A illustrates a schematic diagram of an example threshold voltage distribution of memory cells in a memory device, according to some aspects of the present disclosure. In some implementations, a memory device can perform a program operation on a portion of the memory cells in a memory block to a programmed state (e.g., state P1), while the remaining cells are in an erased state (i.e., state ER). In the example of diagram 510, for a memory device operating in a SLC mode, the threshold voltages Vₜₕ of the memory cells in state ER are in a first voltage range, as shown by the Vₜₕ distribution curve 512. The threshold voltages of the memory cells in state P1 are in a second rage, as shown by Vₜₕ distribution curve 514. For another example, in a memory device operating in a TLC mode, the memory device can program the memory cells to multiple programmed states P1 to P7, while the threshold voltages of the memory cells in each programmed state are in a respective voltage range.

Before performing another program operation, the memory device needs to first perform an erase operation to erase the data stored in the memory cells. In some implementations, the memory device can perform a pre-program operation on the memory cells before performing the erase operation. The pre-program operation can program the memory cells (including memory cells in the erased state and in one or more programmed states) in a memory block to be erased to a pre-programmed state. For example, in a pre-program operation of an SLC memory device, memory cells in state ER can be programmed to the programmed state P1. For another example, in a pre-program operation of a TLC memory device, memory cells in state ER can be programmed to the pre-programmed state similar to state P5, and memory cells in one or more of the other programmed states P1-P7 can also be programmed to the pre-programmed state. The pre-program operation can help prevent the memory cells in the erased state or lower programmed states from being over-erased by the later erase operation.

FIG. 5B illustrates a schematic diagram of an example threshold voltage distribution of memory cells in a memory device after a pre-program operation, according to some aspects of the present disclosure. In some implementations, before performing an erase operation on a memory block, a pre-program voltage can be applied to the control gates of the memory cells in the memory block, and the memory cells can be programmed to a pre-programmed state. The threshold voltages of the memory cells in the pre-programmed state are within a range, as shown by Vₜₕ distribution curve 522. In some implementations, the pre-programmed voltage can be the same as a pre-defined program voltage for a SLC memory device, or can be a pre-defined program voltage for one of the programmed states of a MLC, TLC, or QLC memory device.

In some implementations, after programming the memory cells to be erased to the pre-programmed state, the memory device can perform one or more verify operations to identify the threshold voltage (Vₜₕ) that represents the Vₜₕ distribution of the pre-programmed state. By applying one or more of the read reference voltages (e.g., V_{R1}, V_{R2}, V_{R3}, V_{R4}) to the control gate of the memory cells, the memory device can determine a voltage that represents the Vₜₕ distribution of the memory cells in the pre-programmed state (e.g., the left x-intercept of the Vₜₕ distribution curve 522). For example, a quantity of memory cells in an on-state (i.e., a fail bit count, FBC) when V_{R1} is applied to the control gates of the memory cells is recorded as N₁. N₁ can represent the quantity of the memory cells whose threshold voltage is lower than V_{R1}. Similarly, a quantity of memory cells in an on-state when V_{R2}, V_{R3} or V_{R4} (V_{R1}>V_{R2}>V_{R3}>V_{R4}) is applied to the control gates of the memory cells is recorded as N₂, N₃, N₄, respectively (N₁>N₂>N₃>N₄).

In some implementations, the verify operations can be performed based on read reference voltages from higher to lower. For example, the verify operation using V_{R1} is performed first, and then the verify operations using smaller read reference voltages V_{R2}, V_{R3}, V_{R4} are performed respectively. The threshold voltage can be identified by comparing the FBCs of the read reference voltages to a pre-set threshold. For example, if N₁, N₂ and N₃ are greater than the pre-set threshold, and N₄ is less than the pre-set threshold, V_{R4} is determined as Vₜₕ that represents the Vₜₕ distribution of the pre-programmed state. For another example, if N₁ and N₂ are greater than the pre-set threshold, and N₃ is less than the pre-set threshold, V_{R3} is determined as the Vₜₕ that represents the Vₜₕ distribution of the pre-programmed state, and the verify operation using V_{R4} can be skipped.

In other implementations, the verify operations can be performed based on read reference voltages (e.g., V_{R1}', V_{R2}', V_{R3}' and V_{R4}', where V_{R1}'<V_{R2}'<V_{R3}'<V_{R4}') from lower to higher. V_{R1}' is lower than the left x-intercept of the Vₜₕ distribution curve 522. For example, the verify operation using V_{R1}' is performed first, and then the verify operations using larger read reference voltages V_{R2}', V_{R3}', V_{R4}' are performed respectively. The threshold voltage can be identified by comparing the FBCs of the read reference voltages to a pre-set threshold. For example, if N₁', N₂' and N₃' are less than the pre-set threshold, and N₄' is greater than the pre-set threshold, V_{R4}' is determined as the Vₜₕ that represents the Vₜₕ distribution of the pre-programmed state. For another example, if N₁' and N₂' are less than the pre-set threshold, and N₃' is greater than the pre-set threshold, V_{R3}' is determined as the Vₜₕ that represents the Vₜₕ distribution of the pre-programmed state, and the verify operation using V_{R4}' can be skipped.

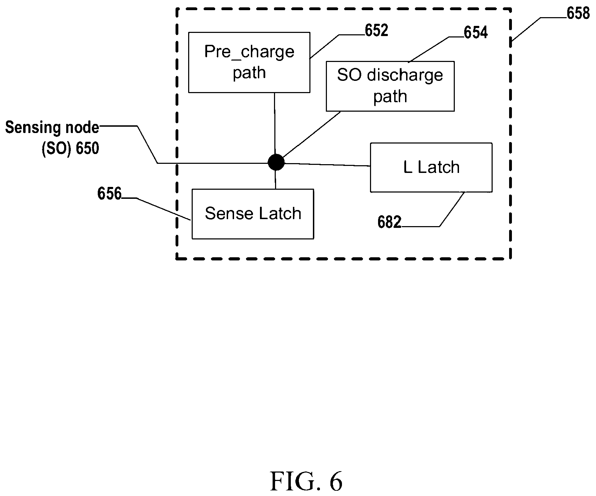

FIG. 6 illustrates example schematic diagram of a page buffer of a memory device, according to some aspects of the present disclosure. FIG. 6 can be described with regard to the page buffer/sense amplifier 304 of FIG. 3. Not all of the depicted components may be used, however, and one or more implementations may include additional components not shown in the figure. Variations in the arrangement and types of the components may be made without departing from the scope of the claims as set forth herein. Additionally, different or fewer components may be provided.

The page buffer includes a plurality of buffer structures 658. In some examples, a page buffer structure 658 connects with the memory string 108 through the bit line 116 of FIG. 1. In some examples, each page buffer of the plurality of page buffers connects with a corresponding memory string through a bit line.

As shown in FIG. 6, the page buffer structure 658 can include a sensing node (aka., sense-out node, or SO) 650, a precharge path 652, a SO discharge path 654, an L latch 682, and a sense latch 656. The page buffer structure 658 can further includes a cache latch and one or more data latches.

As described with reference to FIG. 5B, during a verify operation, the row decoder/word line driver 308 can transfer a read reference voltage V_{R1}, V_{R2}, V_{R3}, or V_{R4} to a selected word line, and a pass voltage Vₚₐₛₛ to an unselected word line. The page buffer can sense current flowing through the bit line 116 that reflects the logic state (i.e., data) of the memory cell 106 and amplify small signal to a measurable magnification. For example, the page buffer structure 658 can precharge the SO 650 through the precharge path 652 by a control circuit (e.g., control logic 312), and can sense at the SO 650 whether a selected memory cell is turned on or off. Specifically, if the threshold voltage of the selected memory cell is lower than the read reference voltage, the selected memory cell should be switched on to form a conductive path in the channel. A charge charged at the SO 650 may be quickly discharged through the channel of the memory string (i.e., through the SO discharge path 654), and the voltage at SO 650 can drop to a low level after a develop period. A logic value 1 may be latched to the sense latch 656. Alternatively, if the threshold voltage of the selected memory cell is higher than the read reference voltage V_{R1}, the selected memory cell should remain switched off. The charge charged at the SO 650 may not be quickly discharged through the channel of the cell string (i.e., through the SO discharge path 654), and the voltage at SO 650 will remain at a high level after the develop period. The page buffer structure 658 can obtain the result of the verify operation by measuring the state of the SO 650 after the develop period. A logic value 0 may be latched to the sense latch 656.

In some implementations, after performing verify operations on all target memory cells (e.g., all the pre-programmed memory cells in a memory block, or all the pre-programmed memory cells coupled to the same word line) using a read reference voltage, the sum of the logic value 1 latched to the sense latch 656 is identified as the FBC of the read reference voltage. For example, after performing a set of verify operations based on a set of read reference voltages V_{R1}, V_{R2}, V_{R3}, and V_{R4}, each read reference voltage can have a corresponding FBC (i.e., N₁, N₂, N₃, N₄ as described with reference to FIG. 5B).

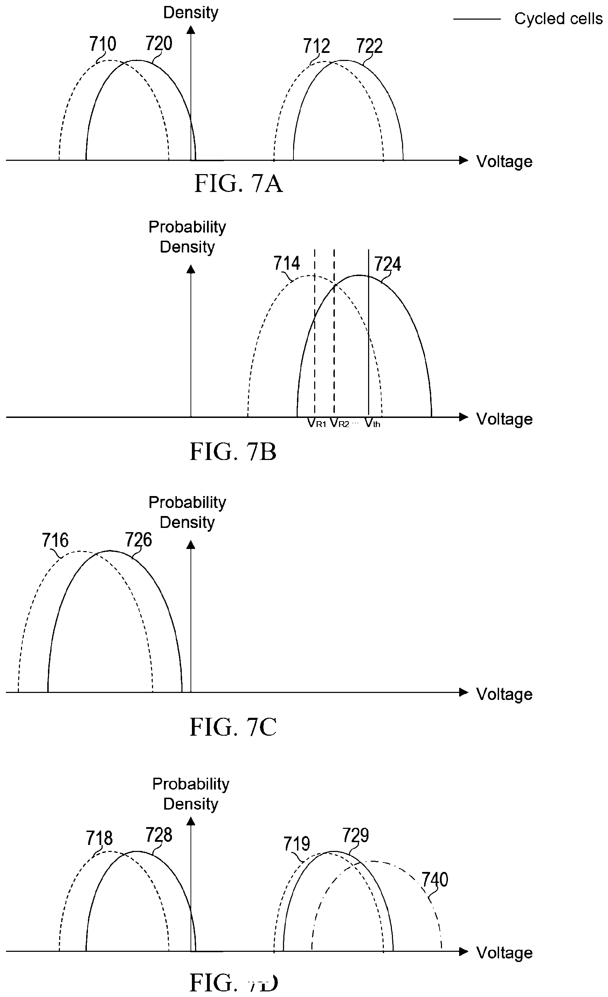

FIG. 7A-7D schematic diagrams of example threshold voltage distributions of memory cells in a memory device, according to some aspects of the present disclosure. Due to multiple factors such as excessive charges trapped in the storage layer, degradation of the insulating oxide layer and wear-and-tear, the memory cells after multiple cycles (e.g., after 500 or 1000 program-erase cycles) can react differently to the same program voltage or the same erase voltage, as compared to memory cells in fresh cycles (e.g., the initial 500 or 1000 program-erase cycles). As shown in FIG. 7A, curve 710 represents a threshold voltage (Vₜₕ) distribution of memory cells in fresh cycles in an erased state. Curve 720 represents a Vₜₕ distribution of memory cells after multiple cycles in an erased state. In some implementations, curve 720 drifts to the right of curve 710. That is, by applying the same erase voltage, the Vₜₕ of memory cells after multiple cycles in the erased state can be higher than the Vₜₕ of the memory cells in fresh cycles in the erased state. Curve 712 represents a Vₜₕ distribution of memory cells in fresh cycles in a programmed state. Curve 722 represents a Vₜₕ distribution of memory cells after multiple cycles in a programmed state. In some implementations, curve 722 drifts to the right of curve 712. That is, by applying the same program voltage, the Vₜₕ of memory cells after multiple cycles in the programmed state can be higher than the Vₜₕ of the memory cells in fresh cycles in the programmed state. As such, the memory cells that have undergone multiple cycles can be over-programmed beyond the intended Vₜₕ level, which can affect the reliability of the memory device.

In some implementations, as discussed with reference to FIG. 5B, prior to erasing data in a memory block, the memory cells in the memory block can first be pre-programmed to a pre-programmed state 522. For example, the pre-program operation can program the memory cells (including memory cells in the erased state and in one or more programmed states) in a memory block to be erased to the same pre-programmed state. After the pre-program operation, the memory device can perform one or more verify operations based on one or more read reference voltages to identify the threshold voltage of the memory cells in the pre-programmed state. As shown in FIG. 7B, curve 714 represents a Vₜₕ distribution of memory cells in fresh cycles in the pre-programmed state. Curve 724 represents a Vₜₕ distribution of memory cells after multiple cycles in the pre-programmed state. In some implementations, curve 724 drifts to the right of curve 714. That is, under the same pre-program voltage, the Vₜₕ of memory cells after multiple cycles in the pre-programmed state can be higher than the Vₜₕ of memory cells in fresh cycles in the pre-programmed state.

In some implementations, a program pulse for a next program operation can be adjusted based on the identified Vₜₕ that represents curve 724. As discussed with reference to FIG. 4A, in a memory device operating in an SLC mode, the memory device can adjust the program pulse 410 for the next program operation, based on the threshold voltage (e.g., V_{R4}) identified by the verify operations that can represent curve 724. For example, the program voltage V_{pgm} of the program pulse 410 can be adjusted to be lower than a pre-defined program voltage V_{pgm_initial}. The difference between the V_{pgm_initial} and V_{pgm} can be positively correlated to the identified Vₜₕ that represents curve 724. For instance, if the Vₜₕ that represents curve 724 is lower than V_{R1}, the program voltage V_{pgm} can remain the same as V_{pgm_initial}. If the Vₜₕ that represents curve 724 is higher than V_{R1} but lower than V_{R2}, the program voltage V_{pgm} can be V_{pgm_initial} - ΔV₁ (e.g., ΔV₁=0.1V). If the Vₜₕ that represents curve 724 is higher than V_{R2} but lower than V_{R3}, the program voltage V_{pgm} can be V_{pgm_initial} - ΔV₂, and ΔV₂ is greater than ΔV₁ (e.g., ΔV₁=0.2V). For another example, the pulse length of the program pulse 410 can be adjusted to be shorter than a pre-defined pulse length.

In some implementations, as discussed with reference to FIG. 4B, in a memory device operating in an MLC, TLC or QLC mode, the memory device can adjust the ISPP scheme 420 for the next program operation based on the Vₜₕ that represents curve 724. For example, the program voltage V_{pgm_start} of the starting program pulse 430 can be adjusted to be lower than a pre-defined program voltage V_{pgm_start_initial}, while the incremental voltage ΔV_{pgm} of the ISPP scheme 420 can remain unchanged. For instance, if the Vₜₕ that represents curve 724 is lower than V_{R1}, the program voltage V_{pgm_start} can remain the same as V_{pgm_start_initial}. If the Vₜₕ that represents curve 724 is higher than V_{R1} but lower than V_{R2}, the program voltage V_{pgm_start} can be V_{pgm_start_initial} - ΔV₁ (e.g., ΔV₁=0.1V). If the Vₜₕ that represents curve 724 is higher than V_{R2} but lower than V_{R3}, the program voltage V_{pgm_start} can be V_{pgm_start_initial} - ΔV₂, and ΔV₂ is greater than ΔV₁ (e.g., ΔV₁=0.2V). For another example, the pulse length of the program pulses 430, 440, 450, 460, 470 can be adjusted to be shorter than a pre-defined pulse length.

In some implementations, the adjusted program voltage or the adjusted pulse length can be stored in a register (e.g., one of the registers 314 in FIG. 3) or a SRAM (not shown) of the memory device 100. As such, the memory device can directly apply the adjusted program voltage or the adjusted pulse length in subsequent program operations.

As shown in FIG. 7C, after the pre-program operation, the memory device performs an erase operation on the memory cells. Curve 716 represents a Vₜₕ distribution of memory cells in fresh cycles in the erased state, similar to curve 710. Curve 726 represents a Vₜₕ distribution of memory cells after multiple cycles in the erased state, similar to curve 720.

As shown in FIG. 7D, in some implementations, the memory device applies the adjusted program voltage in a program operation subsequent to the erase operation. For example, the memory device can apply the pre-defined program voltage V_{pgm_initial} to program memory cells in fresh cycles. As such, the memory cells in the erased state as represented by Vₜₕ distribution curve 718 are programmed to the programmed state as represented by Vₜₕ distribution curve 719. For another example, the memory device can apply the adjusted program voltage V_{pgm} to program memory cells that have undergone multiple cycles. As such, the memory cells in the erased state as represented by Vₜₕ distribution curve 728 are programmed to the programmed state as represented by Vₜₕ distribution curve 729. The Vₜₕ distribution curve 729 is close to the Vₜₕ distribution curve 719, which indicates that the memory cells after multiple cycles can be programmed to the intended Vₜₕ level, instead of being over-programmed. As a comparison, if the memory device applies the pre-defined program voltage V_{pgm_initial} to program memory cells that have undergone multiple cycles, the memory cells can be over-programmed beyond the intended Vₜₕ level, as represented by Vₜₕ distribution curve 740.

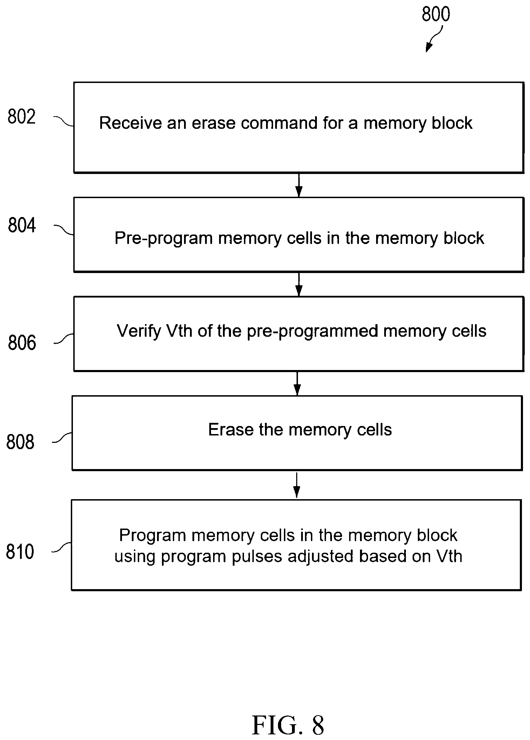

FIG. 8 illustrates an example flow chart of performing a program operation after an erase operation.

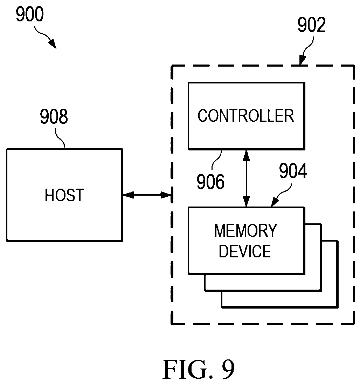

At operation 802, a memory device (e.g., the memory device 100 in FIG. 1) receives an erase command from a memory controller (e.g. the memory controller 906 in FIG. 9) coupled to the memory device. The erase command can indicate to erase data in one or more memory blocks (e.g., block 104 of FIG. 1). In some implementations, other than an erase command from a host (e.g., host 908 of FIG. 9) sent by the memory controller, the erase operation can be triggered by operations such as garbage collection, bad block management, wear-leveling, etc.

At operation 804, the memory device can perform a pre-program operation on the memory block to be erased. For example, the memory device can apply a pre-program voltage through the word lines coupled to the memory cells in the memory block. In some implementations, the pre-programmed voltage can be the same as a pre-defined program voltage for a SLC memory device, or can be a pre-defined program voltage for one of the programmed states of a MLC, TLC, or QLC memory device. The memory cells in the memory block, including the memory cells in the erased state (e.g., curve 720 in FIG. 7A) and in one or more programmed states (e.g., curve 722 in FIG. 7A), are programmed to a pre-programmed state (e.g., curve 724 in FIG. 7B).

At operation 806, the memory device performs a set of verify operations based on a set of read reference voltages on the memory cells in the pre-programmed state. The verify operations can identify a threshold voltage that represents the pre-programmed state (e.g., the left x-intercept of curve 724). In some implementations, the verify operations can determine a fail bit count (FBC) for each read reference voltage. The FBC represents the quantity of memory cells with threshold voltage higher than the read reference voltage. In some implementations, the FBC of each read reference voltage is compared to a pre-set threshold. The read reference voltage from the set of read reference voltages that is identified as the threshold voltage of the programmed state has a FBC smaller than the pre-set threshold.

In some implementations, operation 806 is performed when a quantity of program-erase cycles (P/E cycles) undergone by the memory cells has reached a certain limit. For example, if the quantity of P/E cycles of the memory cells is less than a predetermined threshold (e.g., 500 or 1000 P/E cycles), the memory cells are deemed to be in fresh cycles, where over-programming issue is not severe. Therefore operation 806 can be skipped in method 800. For another example, if the quantity of P/E cycles of the memory cells is greater than the predetermined threshold, the memory cells are deemed to have undergone multiple cycles, where the over-programming issue can affect the reliability of the memory device. Therefore, operation 806 is performed after pre-programming the memory cells in operation 804.

At operation 808, the memory device performs an erase operation on the memory block. As such, the memory cells in the memory block are set to the erased state.

At operation 810, the memory device performs a program operation on the memory block using one or more adjusted program pulses. For example, in response to receiving a program command from the memory controller to write data in the memory block, the memory device can perform a program operation on certain pages of the memory block using the adjusted program pulses, instead of the pre-defined program pulses. In some implementations, the memory device can adjust the program voltage based on the threshold voltage of the programmed state identified in operation 806. For example, the memory device can adjust the program voltage or the pulse length of a program pulse (e.g., the program pulse 410 in FIG. 4A) for an SLC. For another example, the memory device can adjust the program voltage of a starting program pulse (e.g., the starting program pulse 430 in FIG. 4B), or a pulse length of the program pulses (e.g., the program pulse 430, 440, 450, 460, 470 in FIG. 4B) of a ISPP scheme (e.g., the ISPP scheme 420 in FIG. 4B) for an MLC, TLC or QLC.

FIG. 9 illustrates a block diagram of an example system 900 having a memory device, according to some aspects of the present disclosure. System 900 can be a mobile phone, a desktop computer, a laptop computer, a tablet, a vehicle computer, a gaming console, a printer, a positioning device, a wearable electronic device, a smart sensor, a virtual reality (VR) device, an argument reality (AR) device, or any other suitable electronic devices having storage therein. As shown in FIG. 6, system 900 can include a host 908 and a memory system 902 having one or more memory devices 904 and a memory controller 906. Host 908 can be a processor of an electronic device, such as a central processing unit (CPU), or a system-on-chip (SoC), such as an application processor (AP). Host 908 can be configured to send or receive data to or from memory devices 904.

Memory device 904 can be any memory device disclosed in the present disclosure. Memory controller 906 is coupled to memory device 904 and host 908 and is configured to control memory device 904, according to some implementations. Memory controller 906 can manage the data stored in memory device 904 and communicate with host 908. In some implementations, memory controller 906 is designed for operating in a low duty-cycle environment like secure digital (SD) cards, compact Flash (CF) cards, universal serial bus (USB) Flash drives, or other media for use in electronic devices, such as personal computers, digital cameras, mobile phones, etc. In some implementations, memory controller 906 is designed for operating in a high duty-cycle environment SSDs or embedded multi-media-cards (eMMCs) used as data storage for mobile devices, such as smartphones, tablets, laptop computers, etc., and enterprise storage arrays. Memory controller 906 can be configured to control operations of memory device 904, such as read, erase, and program operations. Memory controller 906 can also be configured to manage various functions with respect to the data stored or to be stored in memory device 904 including, but not limited to bad-block management, garbage collection, logical-to-physical address conversion, wear leveling, etc. In some implementations, memory controller 906 is further configured to process error correction codes (ECCs) with respect to the data read from or written to memory device 904. Any other suitable functions may be performed by memory controller 906 as well, for example, formatting memory device 904.

Memory controller 906 can communicate with an external device (e.g., host 908) according to a particular communication protocol. For example, memory controller 906 may communicate with the external device through at least one of various interface protocols, such as a USB protocol, an MMC protocol, a peripheral component interconnection (PCI) protocol, a PCI-express (PCI-E) protocol, an advanced technology attachment (ATA) protocol, a serial-ATA protocol, a parallel-ATA protocol, a small computer small interface (SCSI) protocol, an enhanced small disk interface (ESDI) protocol, an integrated drive electronics (IDE) protocol, a Firewire protocol, etc.

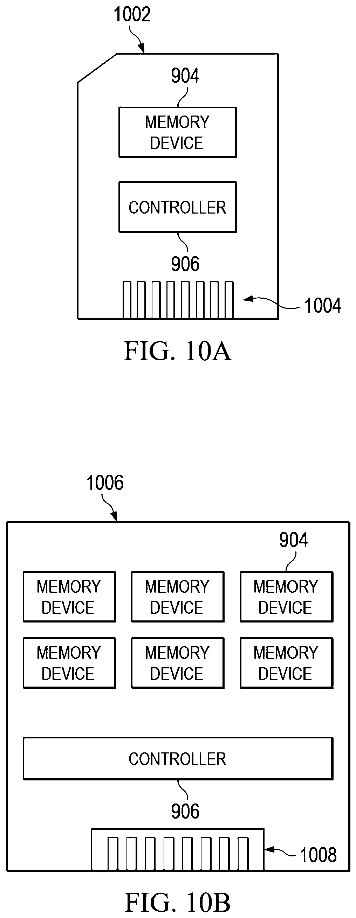

Memory controller 906 and one or more memory devices 904 can be integrated into various types of storage devices, for example, be included in the same package, such as a universal Flash storage (UFS) package or an eMMC package. That is, memory system 902 can be implemented and packaged into different types of end electronic products. In one example as shown in FIG. 10A, memory controller 906 and a memory device 904 may be integrated into a memory card 1002. Memory card 1002 can include a PC card (PCMCIA, personal computer memory card international association), a CF card, a smart media (SM) card, a memory stick, a multimedia card (MMC, RS-MMC, MMCmicro ), an SD card (SD, miniSD, microSD, SDHC), a UFS, etc. Memory card 1002 can further include a memory card connector 1004 coupling memory card 1002 with a host (e.g., host 908 in FIG. 6). In another example as shown in FIG. 10B, memory controller 906 and multiple memory devices 904 may be integrated into an SSD 1006. SSD 1006 can further include an SSD connector 1008 coupling SSD 1006 with a host (e.g., host 908 in FIG. 6). In some implementations, the storage capacity and/or the operation speed of SSD 1006 is greater than those of memory card 1002.

According to one aspect of the present disclosure, a method for operating a memory device is provided. The method includes, before erasing data in a memory block of the memory device, programing memory cells in the memory block to a pre-programmed state, and identifying a threshold voltage of the memory cells in the pre-programmed state. The method further includes, after erasing the data in the memory block, programing memory cells in the memory block using at least one program pulse determined based on the threshold voltage.

The method can include one or more of the following features.

In some implementations, the threshold voltage of the memory cells in the pre-programmed state increases with an increase of a quantity of erase operations performed on the memory block.

In some implementations, programing the memory cells in the memory block to the pre-programmed state includes programming memory cells in an erased state to the pre-programmed state.

In some implementations, identifying the threshold voltage of the memory cells includes applying a set of read voltages to the memory cells, determining a set of fail bit counts (FBCs) of the memory cells corresponding to the set of the read voltages, and identifying the threshold voltage based on the set of FBCs.

In some implementations, identifying the threshold voltage of the memory cells further includes comparing the set of FBCs to a threshold. A FBC associated with a read voltage of the set of the read voltages that is identified as the threshold voltage is less than the threshold.

In some implementations, the memory cells are single-level cells, and the at least one program pulse is a single program pulse. At least one of a program voltage or a pulse length of the single program pulse is determined based on the threshold voltage.

In some implementations, the program voltage is lower than a pre-defined program voltage. A difference between the pre-defined program voltage and the program voltage is positively correlated to a value of the threshold voltage.

In some implementations, the memory cells are multi-level cells, and the at least one program pulse are a plurality of program pulses. At least one of a program voltage of a starting program pulse of the plurality of the program pulses or a pulse length of the plurality of program pulses is determined based on the threshold voltage.

In some implementations, a quantity of erase operations performed on the memory block is greater than a pre-determined threshold.

According to another aspect of the present disclosure, a memory device is provided. The memory device includes a memory array that includes memory blocks and a peripheral circuit. The peripheral circuit is configured to perform operations including, before erasing data in a memory block, programing memory cells in the memory block to a pre-programmed state, and identifying a threshold voltage of the memory cells in the pre-programmed state. The peripheral circuit is further configured to perform operations including, after erasing data in the memory block, programing memory cells in the memory block using at least one program pulse determined based on the threshold voltage.

The memory device can include one or more of the following features.

In some implementations, the threshold voltage of the memory cells in the pre-programmed state increases with an increase of a quantity of erase operations performed on the memory block.

In some implementations, programing the memory cells in the memory block to the pre-programmed state includes programming memory cells in an erased state to the pre-programmed state.

In some implementations, identifying the threshold voltage of the memory cells includes applying a set of read voltages to the memory cells, determining a set of fail bit counts (FBCs) of the memory cells corresponding to the set of the read voltages, and identifying the threshold voltage based on the set of FBCs.

In some implementations, the memory cells are single-level cells, and the at least one program pulse is a single program pulse. At least one of a program voltage or a pulse length of the single program pulse is determined based on the threshold voltage.

In some implementations, the program voltage is lower than a pre-defined program voltage. A difference between the pre-defined program voltage and the program voltage is positively correlated to a value of the threshold voltage.

In some implementations, the memory cells are multi-level cells, and the at least one program pulse are a plurality of program pulses. At least one of a program voltage of a starting program pulse of the plurality of the program pulses or a pulse length of the plurality of program pulses is determined based on the threshold voltage.

In some implementations, a quantity of erase operations performed on the memory block is greater than a pre-determined threshold.

According to another aspect of the present disclosure, a memory system is provided. The memory system includes a memory controller and a memory device coupled the memory controller. The memory device is configured to perform operations including, before erasing data in a memory block, programing memory cells in the memory block to a pre-programmed state, and identifying a threshold voltage of the memory cells in the pre-programmed state. The memory device is further configured to perform operations including, after erasing data in the memory block, programing memory cells in the memory block using at least one program pulse determined based on the threshold voltage.

The memory system can include one or more of the following features.

In some implementations, the memory controller is configured to send a program command to the memory device. The memory device is further configured to, in response to receiving the program command, perform a program operation on the memory cells using the at least one program pulse. A program voltage of the at least one program pulse is lower than a pre-defined program voltage.

While this specification contains many specific implementation details, these should not be construed as limitations on the scope of what may be claimed, but rather as descriptions of features that may be specific to particular implementations. Certain features that are described in this specification in the context of separate implementations can also be implemented, in combination, in a single implementation. Conversely, various features that are described in the context of a single implementation can also be implemented in multiple implementations, separately, or in any sub-combination. Moreover, although previously described features may be described as acting in certain combinations and even initially claimed as such, one or more features from a claimed combination can, in some cases, be excised from the combination, and the claimed combination may be directed to a sub-combination or variation of a sub-combination.

It is noted that references in the specification to "one implementation," "an implementation," "an example implementation," "some implementation," etc., indicate that the implementation described can include a particular feature, structure, or characteristic, but every implementation may not necessarily include the particular feature, structure, or characteristic. Moreover, such phrases do not necessarily refer to the same implementation. Further, when a particular feature, structure or characteristic is described in connection with an implementation, it would be within the knowledge of a person skilled in the pertinent art to affect such feature, structure, or characteristic in connection with other implementations whether or not explicitly described.

In general, terminology can be understood at least in part from usage in context. For example, the term "one or more" as used herein, depending at least in part upon context, can be used to describe any feature, structure, or characteristic in a singular sense or can be used to describe combinations of features, structures, or characteristics in a plural sense. Similarly, terms, such as "a," "an," or "the," again, can be understood to convey a singular usage or to convey a plural usage, depending at least in part upon context. In addition, the term "based on" can be understood as not necessarily intended to convey an exclusive set of factors and can, instead, allow for existence of additional factors not necessarily expressly described, again, depending at least in part on context.

As used herein, the term "substrate" refers to a material onto which subsequent material layers are added. The substrate includes a "top" surface and a "bottom" surface. The top surface of the substrate is typically where a semiconductor device is formed, and therefore the semiconductor device is formed at a top side of the substrate unless stated otherwise. The bottom surface is opposite to the top surface and therefore a bottom side of the substrate is opposite to the top side of the substrate. The substrate itself can be patterned. Materials added on top of the substrate can be patterned or can remain unpatterned. Furthermore, the substrate can include a wide array of semiconductor materials, such as silicon, germanium, gallium arsenide, indium phosphide, etc. Alternatively, the substrate can be made from an electrically non-conductive material, such as a glass, a plastic, or a sapphire wafer.

As used herein, the term "layer" refers to a material portion including a region with a thickness. A layer has a top side and a bottom side where the bottom side of the layer is relatively close to the substrate and the top side is relatively away from the substrate. A layer can extend over the entirety of an underlying or overlying structure, or can have an extent less than the extent of an underlying or overlying structure. Further, a layer can be a region of a homogeneous or inhomogeneous continuous structure that has a thickness less than the thickness of the continuous structure. For example, a layer can be located between any set of horizontal planes between, or at, a top surface and a bottom surface of the continuous structure. A layer can extend horizontally, vertically, and/or along a tapered surface. A substrate can be a layer, can include one or more layers therein, and/or can have one or more layer thereupon, there above, and/or there below. A layer can include multiple layers. For example, an interconnect layer can include one or more conductive and contact layers (in which contacts, interconnect lines, and/or vertical interconnect accesses (VIAs) are formed) and one or more dielectric layers.

As used in this disclosure, the term "about" or "approximately" can allow for a degree of variability in a value or range, for example, within 10%, within 5%, or within 1% of a stated value or of a stated limit of a range.

As used in this disclosure, the term "substantially" refers to a majority of, or mostly, as in at least about 50%, 60%, 70%, 80%, 90%, 95%, 96%, 97%, 98%, 99%, 99.5%, 99.9%, 99.99%, or at least about 99.999% or more.

Values expressed in a range format should be interpreted in a flexible manner to include not only the numerical values explicitly recited as the limits of the range, but also to include the individual numerical values or sub-ranges encompassed within that range as if each numerical value and sub-range is explicitly recited. For example, a range of "0.1% to about 5%" or "0.1% to 5%" should be interpreted to include about 0.1% to about 5%, as well as the individual values (for example, 1%, 2%, 3%, and 4%) and the sub-ranges (for example, 0.1% to 0.5%, 1.1% to 2.2%, 3.3% to 4.4%) within the indicated range. The statement "X to Y" has the same meaning as "about X to about Y," unless indicated otherwise. Likewise, the statement "X, Y, or Z" has the same meaning as "about X, about Y, or about Z," unless indicated otherwise.

Particular implementations of the subject matter have been described. Other implementations, alterations, and permutations of the described implementations are within the scope of the following claims as will be apparent to those skilled in the art. While operations are depicted in the drawings or claims in a particular order, such operations are not required be performed in the particular order shown or in sequential order, or that all illustrated operations be performed (some operations may be considered optional), to achieve desirable results. In certain circumstances, multitasking or parallel processing (or a combination of multitasking and parallel processing) may be advantageous and performed as deemed appropriate.

Moreover, the separation or integration of various system modules and components in the previously described implementations are not required in all implementations, and the described components and systems can generally be integrated together or packaged into multiple products.

Accordingly, the previously described example implementations do not define or constrain the present disclosure. Other changes, substitutions, and alterations are also possible without departing from the scope of the present disclosure.

## Claims

1. A method (800) of operating a memory device (100; 904), comprising:
before erasing (808) data in a memory block (104) of the memory device (100; 904):
programming (804) memory cells (106) in the memory block (104) to a pre-programmed state; and
identifying (806) a threshold voltage of the memory cells (106) in the pre-programmed state; and,
after erasing (808) the data in the memory block (104), programming (810) memory cells (106) in the memory block (104) using at least one program pulse (410; 430-470) determined based on the threshold voltage, **characterised in that** identifying (806) the threshold voltage of the memory cells (106) comprises:
applying a set of read voltages to the memory cells (106);
determining a set of fail bit counts, FBCs, of the memory cells (106) corresponding to the set of the read voltages; and
identifying the threshold voltage based on the set of FBCs.

2. The method (800) of claim 1, wherein
the threshold voltage of the memory cells (106) in the pre-programmed state increases with an increase of a quantity of erase operations performed on the memory block (104), and/or
a quantity of erase operations performed on the memory block (104) is greater than a pre-determined threshold.

3. The method (800) of claim 1 or 2, wherein programming (804) the memory cells (106) in
the memory block (104) to the pre-programmed state comprises:
programming memory cells (106) in an erased state to the pre-programmed state.

4. The method (800) of any one of claims 1 to 3, wherein identifying (806) the threshold voltage of the memory cells (106) comprises:
comparing the set of FBCs to a threshold, wherein a FBC associated with a read voltage of the set of the read voltages that is identified as the threshold voltage is less than the threshold.

5. The method (800) of any one of claims 1 to 4, wherein the memory cells (106) are single-level cells (106), wherein the at least one program pulse (410) is a single program pulse (410), and wherein at least one of a program voltage of the single program pulse (410) or a pulse length of the single program pulse (410) is determined based on the threshold voltage, .

6. The method of claim 5, wherein the program voltage is lower than a pre-defined program voltage, wherein a difference between the pre-defined program voltage and the program voltage is positively correlated to a value of the threshold voltage.

7. The method of any one of claims 1 to 4, wherein the memory cells are multi-level cells (106), wherein the at least one program pulse (430-470) are a plurality of program pulses (430-470), and wherein at least one of a program voltage of a starting program pulse (430) of the plurality of the program pulses (430-470) or a pulse length of the plurality of program pulses (430-470) is determined based on the threshold voltage.

8. A memory device (100; 904) comprising:
a memory array (101) comprising memory blocks (104); and
a peripheral circuit (102) configured to perform operations comprising:
before erasing (808) data in a memory block (104):
programming (804) memory cells (106) in the memory block (104) to a pre-programmed state; and
identifying (806) a threshold voltage of the memory cells (106) in the pre-programmed state; and
after erasing (808) data in the memory block (104), programming (810) memory cells (106) in the memory block (104) using at least one program pulse (410; 430-470) determined based on the threshold voltage, **characterised in that** identifying (806) the threshold voltage of the memory cells (106) comprises:
applying a set of read voltages to the memory cells (106);
determining a set of fail bit counts, FBCs, of the memory cells (106) corresponding to the set of the read voltages; and
identifying the threshold voltage based on the set of FBCs.

9. The memory device (100; 904) of claim 8, wherein
the threshold voltage of the memory cells (106) in the pre-programmed state increases with an increase of a quantity of erase operations performed on the memory block (104), and/or
a quantity of erase operations performed on the memory block (104) is greater than a pre-determined threshold, and/or
the memory device (100; 904) comprises a NAND memory device.

10. The memory device (100; 904) of claim 8 or 9, wherein programing (804) the memory cells (106) in the memory block (104) to the pre-programmed state comprises:
programming memory cells (106) in an erased state to the pre-programmed state.

11. The memory device (100; 904) of any one of claims 8 to 10, wherein the memory cells (106) are single-level cells, wherein the at least one program pulse (410) is a single program pulse (410), and wherein at least one of a program voltage of the single program pulse (410) or a pulse length of the single program pulse (410) is determined based on the threshold voltage.

12. The memory device of claim 11, wherein the program voltage is lower than a pre-defined program voltage, wherein a difference between the pre-defined program voltage and the program voltage is positively correlated to a value of the threshold voltage.

13. The memory device of any one of claims 8 to 10, wherein the memory cells are multi-level cells, wherein the at least one program pulse (430-470) are a plurality of program pulses (430-470), and wherein at least one of a program voltage of a starting program pulse (430) of the plurality of the program pulses (430-470) or a pulse length of the plurality of program pulses (430-470) is calculated based on the threshold voltage.

14. A memory system (902) comprising:
a memory controller (906); and
a memory device (100; 904) according to claim 8 coupled to the memory controller.

15. The memory system (902) of claim 14, wherein the memory controller (906) is configured to send a program command to the memory device (100; 904), and wherein the memory device (100; 904) is further configured to:
in response to receiving the program command, perform a program operation on the memory cells (106) using the at least one program pulse (410; 430-470), wherein a program voltage of the at least one program pulse (410; 430-470) is lower than a pre-defined program voltage.

## Patentansprüche

1. Verfahren (800) zum Betrieb einer Speichervorrichtung (100; 904), umfassend:
vor dem Löschen (808) von Daten in einem Speicherblock (104) der Speichervorrichtung (100; 904):
Programmieren (804) von Speicherzellen (106) in dem Speicherblock (104) in einen vorprogrammierten Zustand; und
Identifizieren (806) einer Schwellenspannung der Speicherzellen (106) im vorprogrammierten Zustand; und
nach dem Löschen (808) der Daten in dem Speicherblock (104),
Programmieren (810) von Speicherzellen (106) in dem Speicherblock (104) unter Verwendung zumindest eines auf der Basis der Schwellenspannung bestimmten Programmierimpulses (410; 430-470), **dadurch gekennzeichnet, dass** das Identifizieren (806) der Schwellenspannung der Speicherzellen (106) umfasst:
Anlegen einer Gruppe von Lesespannungen an die Speicherzellen (106);
Ermitteln einer Gruppe von Bitfehler-Zählern, FBCs, der Speicherzellen (106) entsprechend der Gruppe von Lesespannungen; und
Identifizieren der Schwellenspannung basierend auf der Gruppe von FBCs.

2. Verfahren (800) nach Anspruch 1, wobei
die Schwellenspannung der Speicherzellen (106) im vorprogrammierten Zustand mit zunehmender Anzahl von an dem Speicherblock (104) durchgeführten Löschvorgängen zunimmt und/oder
eine Anzahl von an dem Speicherblock (104) durchgeführten Löschvorgängen größer ist als ein vorgegebener Schwellenwert.

3. Verfahren (800) nach Anspruch 1 oder 2, wobei das Programmieren (804) der Speicherzellen (106) im Speicherblock (104) in den vorprogrammierten Zustand umfasst:
Programmieren von Speicherzellen (106) in einem gelöschten Zustand in den vorprogrammierten Zustand.

4. Verfahren (800) nach einem der Ansprüche 1 bis 3, wobei das Identifizieren (806) der Schwellenspannung der Speicherzellen (106) umfasst:
Vergleichen einer Gruppe von FBCs mit einem Schwellenwert, wobei ein FBC, der einer als Schwellenspannung identifizierten Lesespannung der Gruppe von Lesespannungen zugeordnet ist, kleiner ist als der Schwellenwert.

5. Verfahren (800) nach einem der Ansprüche 1 bis 4, wobei die Speicherzellen (106) Einzel-Ebenen-Zellen (106) sind, wobei der zumindest eine Programmierimpuls (410) ein einzelner Programmierimpuls (410) ist und wobei von einer Programmierspannung des einzelnen Programmierimpulses (410) oder einer Impulslänge des einzelnen Programmierimpulses (410) zumindest eine basierend auf der Schwellenspannung bestimmt wird.

6. Verfahren nach Anspruch 5, wobei die Programmierspannung niedriger ist als eine vordefinierte Programmierspannung und wobei die Programmierspannung mit einem Wert der Schwellenspannung positiv korreliert ist.

7. Verfahren nach einem der Ansprüche 1 bis 4, wobei die Speicherzellen Mehr-Ebenen-Zellen (106) sind, wobei der zumindest eine Programmierimpuls (430-470) aus mehreren Programmierimpulsen (430-470) besteht und wobei von einer Programmierspannung eines Start-Programmierimpulses (430) der mehreren Programmierimpulse (430-470) oder einer Impulslänge der mehreren Programmierimpulse (430-470) zumindest eine basierend auf der Schwellenspannung bestimmt wird.

8. Speichervorrichtung (100; 904), umfassend:
ein Speicher-Array (101) mit Speicherblöcken (104); und
eine Peripherieschaltung (102), die konfiguriert ist für die Durchführung von Vorgängen umfassend:
vor dem Löschen (808) von Daten in einem Speicherblock (104):
Programmieren (804) von Speicherzellen (106) in dem Speicherblock (104) in einen vorprogrammierten Zustand; und
Identifizieren (806) einer Schwellenspannung der Speicherzellen (106) im vorprogrammierten Zustand; und
nach dem Löschen (808) der Daten in dem Speicherblock (104):
Programmieren (810) von Speicherzellen (106) in dem Speicherblock (104) unter Verwendung zumindest eines auf der Basis der Schwellenspannung bestimmten Programmierimpulses (410; 430-470)
**dadurch gekennzeichnet, dass** das Identifizieren (806) der Schwellenspannung der Speicherzellen (106) umfasst:
Anlegen einer Gruppe von Lesespannungen an die Speicherzellen (106);
Ermitteln einer Gruppe von Bitfehler-Zählern, FBCs, der Speicherzellen (106) entsprechend der Gruppe von Lesespannungen; und
Identifizieren der Schwellenspannung basierend auf der Gruppe von FBCs.

9. Speichervorrichtung (100; 904)nach Anspruch 8, wobei die Schwellenspannung der Speicherzellen (106) im vorprogrammierten Zustand mit zunehmender Anzahl von an dem Speicherblock (104) durchgeführten Löschvorgängen zunimmt und/oder
eine Anzahl von an dem Speicherblock (104) durchgeführten Löschvorgängen größer ist als ein vorgegebener Schwellenwert und/oder
die Speichervorrichtung (100; 904) eine NAND-Speichervorrichtung umfasst.

10. Speichervorrichtung (100; 904) nach Anspruch 8 oder 9, wobei das Programmieren (804) der Speicherzellen (106) im Speicherblock (104) in den vorprogrammierten Zustand umfasst:
Programmieren von Speicherzellen (106) in einem gelöschten Zustand in den vorprogrammierten Zustand.

11. Speichervorrichtung (100; 904) nach einem der Ansprüche 8 bis 10, wobei die Speicherzellen (106) Einzel-Ebenen-Zellen sind, wobei der zumindest eine Programmierimpuls (410) ein einzelner Programmierimpuls (410) ist und wobei von einer Programmierspannung des einzelnen Programmierimpulses (410) oder einer Impulslänge des einzelnen Programmierimpulses (410) zumindest eine basierend auf der Schwellenspannung bestimmt wird.

12. Speichervorrichtung nach Anspruch 11, wobei die Programmierspannung niedriger ist als eine vordefinierte Programmierspannung und wobei die Programmierspannung mit einem Wert der Schwellenspannung positiv korreliert ist.

13. Speichervorrichtung nach einem der Ansprüche 8 bis 10, wobei die Speicherzellen Mehr-Ebenen-Zellen sind, wobei der zumindest eine Programmierimpuls (430-470) aus mehreren Programmierimpulsen (430-470) besteht und wobei von einer Programmierspannung eines Start-Programmierimpulses (430) der mehreren Programmierimpulse (430-470) oder einer Impulslänge der mehreren Programmierimpulse (430-470) zumindest eine basierend auf der Schwellenspannung berechnet wird.

14. Speichersystem (902), umfassend:
einen Speicher-Controller (906); und
eine mit dem Speicher-Controller verbundene Speichervorrichtung (100; 904) nach Anspruch 8.

15. Speichersystem (902) nach Anspruch 14, wobei der Speicher-Controller (906) dazu eingerichtet ist, einen Programmbefehl an die Speichervorrichtung (100; 904) zu senden, und wobei die Speichervorrichtung (100; 904) ferner dazu eingerichtet ist:
in Reaktion auf den Empfang des Programmbefehls eine Programmieroperation an den Speicherzellen (106) unter Verwendung des zumindest einen Programmierimpulses (410; 430-470) durchzuführen, wobei eine Programmierspannung des zumindest einen Programmierimpulses (410; 430-470) niedriger ist als eine vordefinierte Programmierspannung.

## Revendications

1. Procédé (800) de fonctionnement d'un dispositif de mémoire (100; 904), comprenant:
avant l'effacement (808) de données dans un bloc de mémoire (104) du dispositif de mémoire (100; 904):
la programmation (804) des cellules de mémoire (106) dans le bloc de mémoire (104) dans un état préprogrammé; et
l'identification (806) d'une tension de seuil des cellules de mémoire (106) dans l'état préprogrammé; et
après l'effacement (808) des données dans le bloc de mémoire (104),
la programmation (810) des cellules de mémoire (106) dans le bloc de mémoire (104) en utilisant au moins une impulsion de programmation (410; 430-470) déterminée sur la base de la tension de seuil, **caractérisé en ce que** l'identification (806) de la tension de seuil des cellules de mémoire (106) comprend:
l'application d'un ensemble de tensions de lecture aux cellules de mémoire (106);
la détermination d'un ensemble de compteurs d'erreurs de bits (FBC) des cellules de mémoire (106) correspondant à l'ensemble de tensions de lecture; et
l'identification de la tension de seuil sur la base de l'ensemble de FBC.

2. Procédé (800) selon la revendication 1, dans lequel
la tension de seuil des cellules de mémoire (106) à l'état préprogrammé augmente à mesure que le nombre d'opérations d'effacement effectuées sur le bloc de mémoire (104) augmente et/ou
le nombre d'opérations d'effacement effectuées sur le bloc de mémoire (104) est supérieur à une valeur seuil prédéfinie.

3. Procédé (800) selon la revendication 1 ou 2, dans lequel la programmation (804) des cellules de mémoire (106) dans le bloc de mémoire (104) dans l'état préprogrammé comprend:
la programmation de cellules de mémoire (106) se trouvant dans un état effacé vers l'état préprogrammé.

4. Procédé (800) selon l'une quelconque des revendications 1 à 3, dans lequel l'identification (806) de la tension de seuil des cellules de mémoire (106) comprend:
la comparaison d'un groupe de FBC à une valeur seuil, un FBC associé à une tension de lecture identifiée comme tension de seuil parmi le groupe de tensions de lecture étant inférieure à la valeur seuil.

5. Procédé (800) selon l'une quelconque des revendications 1 à 4, dans lequel les cellules de mémoire (106) sont des cellules à niveau unique (106), dans lequel ladite au moins une impulsion de programmation (410) est une impulsion de programmation unique (410) et dans lequel, parmi une tension de programmation de ladite impulsion de programmation unique (410) ou une durée d'impulsion de ladite impulsion de programmation unique (410), au moins l'une est déterminée sur la base de la tension de seuil.

6. Procédé selon la revendication 5, dans lequel la tension de programmation est inférieure à une tension de programmation prédéfinie et dans lequel la tension de programmation est en corrélation positive avec une valeur de la tension de seuil.

7. Procédé selon l'une quelconque des revendications 1 à 4, dans lequel les cellules de mémoire sont des cellules à plusieurs niveaux (106), dans lequel ladite au moins une impulsion de programmation (430-470) est constituée de plusieurs impulsions de programmation (430-470) et dans lequel, parmi la tension de programmation d'une impulsion de programmation de départ (430) parmi les multiples impulsions de programmation (430-470) ou d'une longueur d'impulsion parmi les multiples impulsions de programmation (430-470), au moins l'une est déterminée sur la base de la tension de seuil.

8. Dispositif de mémoire (100; 904) comprenant:
une matrice de mémoire (101) comportant des blocs de mémoire (104); et
un circuit périphérique (102) configuré pour exécuter des opérations comprenant:
avant l'effacement (808) de données dans un bloc de mémoire (104):
la programmation (804) de cellules de mémoire (106) dans le bloc de mémoire (104) dans un état préprogrammé; et
l'identification (806) d'une tension de seuil des cellules de mémoire (106) dans l'état préprogrammé; et
après l'effacement (808) des données dans le bloc de mémoire (104),
la programmation (810) des cellules de mémoire (106) dans le bloc de mémoire (104) en utilisant au moins une impulsion de programmation (410; 430-470) déterminée sur la base de la tension de seuil, **caractérisé en ce que** l'identification (806) de la tension de seuil des cellules de mémoire (106) comprend:
l'application d'un ensemble de tensions de lecture aux cellules de mémoire (106);
la détermination d'un ensemble de compteurs d'erreurs de bits (FBC) des cellules de mémoire (106) correspondant à l'ensemble de tensions de lecture; et
l'identification de la tension de seuil sur la base de cet ensemble de FBC.

9. Dispositif de mémoire (100; 904)selon la revendication 8, dans lequel la tension de seuil des cellules de mémoire (106) à l'état préprogrammé augmente à mesure que le nombre d'opérations d'effacement effectuées sur le bloc de mémoire (104) augmente et/ou
le nombre d'opérations d'effacement effectuées sur le bloc de mémoire (104) est supérieur à une valeur seuil prédéfinie et/ou
le dispositif de mémoire (100; 904) comprend un dispositif de mémoire NAND.

10. Dispositif de mémoire (100; 904) selon la revendication 8 ou 9, dans lequel la programmation (804) des cellules de mémoire (106) dans le bloc de mémoire (104) à l'état préprogrammé comprend:
la programmation de cellules de mémoire (106) se trouvant dans un état effacé pour les amener à l'état préprogrammé.

11. Dispositif de mémoire (100; 904) selon l'une quelconque des revendications 8 à 10, dans lequel les cellules de mémoire (106) sont des cellules à un seul niveau, dans lequel ladite au moins une impulsion de programmation (410) est une impulsion de programmation unique (410) et dans lequel, parmi la tension de programmation de l'impulsion de programmation unique (410) ou la durée de l'impulsion de programmation unique (410), au moins l'une est déterminée sur la base de la tension de seuil.

12. Dispositif de mémoire selon la revendication 11, dans lequel la tension de programmation est inférieure à une tension de programmation prédéfinie et dans lequel la tension de programmation est en corrélation positive avec une valeur de la tension de seuil.

13. Dispositif de mémoire selon l'une quelconque des revendications 8 à 10, dans lequel les cellules de mémoire sont des cellules à plusieurs niveaux, dans lequel ladite au moins une impulsion de programmation (430-470) est constituée de plusieurs impulsions de programmation (430-470) et dans lequel au moins l'une parmi une tension de programmation d'une impulsion de programmation de départ (430) parmi les multiples impulsions de programmation (430-470) ou une longueur d'impulsion parmi les multiples impulsions de programmation (430-470) est calculée sur la base de la tension de seuil.

14. Système de mémoire (902) comprenant:
un contrôleur de mémoire (906); et
un dispositif de mémoire (100; 904) selon la revendication 8, connecté au contrôleur de mémoire.

15. Système de mémoire (902) selon la revendication 14, dans lequel le contrôleur de mémoire (906) est agencé pour envoyer une commande de programmation au dispositif de mémoire (100; 904), et dans lequel le dispositif de mémoire (100; 904) est en outre agencé pour:
en réponse à la réception de la commande de programmation, effectuer une opération de programmation sur les cellules de mémoire (106) en utilisant ladite au moins une impulsion de programmation (410; 430-470), la tension de programmation de ladite au moins une impulsion de programmation (410; 430-470) étant inférieure à une tension de programmation prédéfinie.
